# EUROPEAN PATENT APPLICATION

(11) **EP 1 148 152 A2**
(43) Date of publication of application: **24.10.2001**
(21) Application number: 01109677.3
(22) Date of filing: 19.04.2001
(51) Int. Cl.: C23C 16/48, C23C 16/458

(54) **Chemical vapor deposition apparatus**

(30) Priority: 21.04.2000 JP 2000120743
(71) Applicant: SONY CORPORATION, Tokyo 141 (JP)
(72) Inventor: Mizuno, Shinichi, Shinagawa-ku, Tokyo (JP)
(74) Representative: MÜLLER & HOFFMANN Patentanwälte

(57) **Abstract**

A thermal CVD apparatus is provided with a substrate heating source which includes a reaction chamber and an electromagnetic wave generator connecting to the reaction chamber. Silicon substrates are placed in the reaction chamber. The electromagnetic wave generator supplies electromagnetic waves to the reaction chamber to form a thin film on the front face of each silicon substrate. Alternatively, the thermal CVD apparatus may be provided with a cavity resonator for placing the substrates therein and the electromagnetic wave generator may be connected to the cavity resonator.

## Description

### BACKGROUND OF THE INVENTION

### 1. Field of the Invention

The present invention relates to chemical vapor deposition apparatuses (hereinafter, chemical vapor deposition is referred to as CVD) and particularly to a thermal CVD apparatus for depositing a monocrystalline semiconductor thin-film by epitaxial growth.

### 2. Description of the Related Art

A thermal CVD apparatus is known as one of the apparatuses for epitaxial growth. In general, the epitaxial growth apparatuses facilitate epitaxial growth on substrates which are placed on susceptors and heated together therewith. The epitaxial growth apparatuses are classified into horizontal apparatuses, vertical apparatuses, cylindrical apparatuses, hot wall apparatuses, cluster apparatuses, single-wafer processing apparatuses, and the like. These apparatuses are disclosed in pages 411 to 414 of "Science of Silicon" (Realize Inc.) (Chapter 5, Section 3 "Epitaxial Wafer Production Technology").

Apparatuses using electromagnetic waves such as etching apparatuses by microwave plasma and plasma enhanced CVD apparatuses are also disclosed. For example, microwaves are confined in a cavity resonator or a ring cavity resonator, as disclosed in Japanese Unexamined Patent Application Publication No. 9-270386.

However, these epitaxial growth apparatuses have the following problems: A common problem in these apparatuses is low energy efficiency, since a substrate placed on a susceptor is indirectly heated by heating the susceptor. In other words, the susceptor must also be heated. Moreover, only the face away from the susceptor of the substrate is cooled by gas flow; hence, the substrate thermally deforms and slip defects occur in the epitaxial layer. In addition, individual apparatuses have the following problems.

Horizontal apparatuses and vertical apparatuses are not suitable for mass production since substrates cannot be stacked due to the structures thereof. Since cylindrical apparatuses require a considerably large reaction chamber for single-wafer processing, it is difficult to construct an apparatus large enough to meets trends towards an increase in size of the substrate. Hot wall apparatuses strongly heat the periphery of the substrate by the skin effect in high-frequency induction heating. Although the temperature gradient is moderated by heat conduction in the substrate and heat radiation from the upper and lower substrates, it takes a significant amount of time for the temperature distribution to become uniform, thus impairing volume efficiency. Since radiant heating using a halogen lamp strongly heats the periphery of the substrate, it takes a significant amount of time for the temperature distribution to become uniform, thus impairing volume efficiency. The single-wafer process which basically processes a single wafer at a time does not have volume efficiency.

### SUMMARY OF THE INVENTION

Accordingly, it is an object of the present invention to provide a chemical vapor deposition apparatus which does not have the above problems.

According to a first aspect of the present invention, a chemical vapor deposition apparatus comprises a reaction chamber for forming a thin film on a face of a substrate placed therein; and a substrate heater having an electromagnetic wave generator connecting to the reaction chamber for supplying electromagnetic waves to the reaction chamber.

The chemical vapor deposition apparatus according to the first aspect has the electromagnetic wave generator which connects to the reaction chamber and supplies electromagnetic waves to the reaction chamber. The substrate placed in the reaction chamber is heated by electromagnetic waves which are supplied from the electromagnetic wave generator. The heating source using electromagnetic waves simultaneously and uniformly heats a plurality of substrates placed in the reaction chamber in a short time.

Preferably, the chemical vapor deposition apparatus further comprises a holder for holding the substrate in the reaction chamber, the holder having an opening in a region the substrate is placed.

In this chemical vapor deposition apparatus, the substrate is held on the holder having the opening so that the back face of the substrate lies at the opening. Thus, the two faces of the substrate held on the holder are exposed. Since the substrate selectively consumes electromagnetic wave energy in the region in which it is held, the substrate can be heated using less energy.

Preferably, the substrate and the holder are arranged such that a structure constituted by the substrate and the holder confines the electromagnetic waves.

A plurality of substrates may be arrayed three-dimensionally in this configuration and may be treated simultaneously.

According to a second aspect of the present invention, a chemical vapor deposition apparatus comprises a cavity resonator for placing a substrate therein; and a substrate heater having an electromagnetic wave generator connecting to the cavity resonator for supplying electromagnetic waves to the cavity resonator.

The chemical vapor deposition apparatus according to a second aspect has the electromagnetic wave generator which connects to the cavity resonator and supplies electromagnetic waves to the cavity resonator. The substrate placed in the cavity resonator is heated by electromagnetic waves which are supplied from the electromagnetic wave generator to the cavity resonator. The heating source using electromagnetic waves can simultaneously and uniformly heat a plurality of substrates placed in the cavity resonator in a short time.

Preferably, the chemical vapor deposition apparatus further comprises a holder for holding the substrate in the cavity resonator, the holder being provided with an opening in the region the substrate is placed.

In this chemical vapor deposition apparatus, the substrate is held on the holder having the opening so that the back face of the substrate lies at the opening. Thus, the two faces of the substrate held on the holder are exposed. Since the substrate selectively consumes electromagnetic wave energy in a region holding the substrate, the substrate can be heated by reduced energy.

Preferably, the substrate and the holder are arranged so that a structure constituted by the substrate, the holder, and the cavity resonator confines the electromagnetic waves.

In such a configuration, a plurality of substrates may be arrayed three-dimensionally and may be treated simultaneously.

Preferably, the internal face of the cavity resonator is covered with a coating film which comprises a corrosion-resistant material and which reflects radiation (primarily infrared radiation) from the heated substrate.

The coating applied on the internal face of the cavity resonator enhances confinement effects of radiation (primarily infrared radiation) from the heated substrate. Thus, the input energy is more effectively used for heating the substrate.

### BRIEF DESCRIPTION OF THE DRAWINGS

Fig. 1 is a partially cut-away isometric view of an overall configuration of a first CVD apparatus according to the first aspect of the present invention;
Fig. 2 is a partially enlarged cross-sectional view of a holder of the first thermal CVD apparatus shown in Fig. 1;
Fig. 3 is a partially cut-away isometric view of an overall configuration of a second thermal CVD apparatus according to a second aspect of the present invention;
Fig. 4A is a partially cut-away isometric view of an overall configuration of a third thermal CVD apparatus according to the second aspect of the present invention; and Fig. 4B is an enlarged cross-sectional view taken from line IVB-IVB in Fig. 4A;
Fig. 5 is a partially cut-away isometric view of an overall configuration of a fourth thermal CVD apparatus according to the second aspect of the present invention;
Fig. 6 is an outline diagram illustrating a configuration of an electromagnetic wave generator;
Fig. 7 is another outline diagram illustrating a configuration of an electromagnetic wave generator;
Fig. 8 is a partially cut-away isometric view of an overall configuration of an eighth thermal CVD apparatus according to the second aspect of the present invention; and
Fig. 9 is a partially cut-away isometric view of an overall configuration of a ninth thermal CVD apparatus according to the second aspect of the present invention.

### DESCRIPTION OF THE PREFERRED EMBODIMENTS

### First Thermal CVD Apparatus

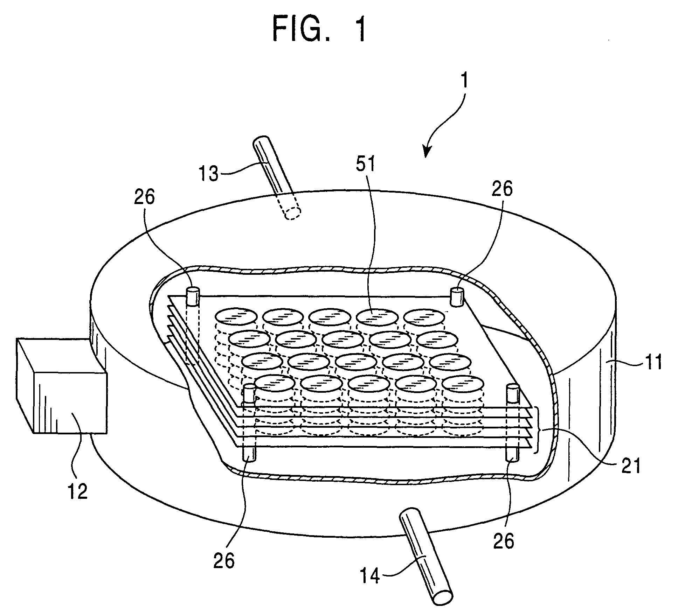

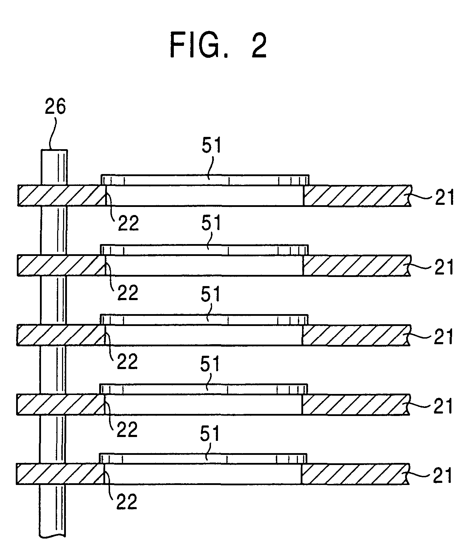

The chemical vapor deposition apparatus according to the first aspect in accordance with the present invention (hereinafter referred to as a first thermal CVD apparatus) will be described with reference to Fig. 1 which is a partially cut-away view of an overall configuration thereof and Fig. 2 is a partially enlarged cross-sectional view of a component.

With reference to Fig. 1, the first thermal CVD apparatus 1 heats a substrate (hereinafter referred to as a silicon substrate) in a reaction chamber to an elevated temperature of approximately 1,000°C and supplies a silicon-containing compound to the reaction chamber. Thin-film monocrystalline silicon is formed and is deposited onto the silicon substrate by pyrolysis of the silicon-containing compound.

As shown in Fig. 1, the thermal CVD apparatus 1 is provided with a reaction chamber 11 formed of, for example, synthetic quartz. In the interior of the reaction chamber 11, a plurality of holders, for example, five holders 21 are vertically arranged so that a plurality of silicon substrates 51 may be placed thereon. These holders 21 are arranged at predetermined intervals by a holder supporter 26. The holders 21 will be described below in detail. An electromagnetic wave generator 12 is connected to a side face of the reaction chamber 11. The electromagnetic wave generator 12 supplies electromagnetic waves to the interior of the reaction chamber 21. For example, a magnetron is used as the electromagnetic wave generator 12. The oscillation frequency thereof is in the microwave or millimeter band. In this embodiment, 2.46 GHz microwaves are generated as an example. The reaction chamber 11 is connected to a gas supply pipe 13 and a gas exhaust pipe 14

The holders 21 will now be described. With reference to Fig. 2, each holder 21 supported by the holder supporter 26 has an opening 22 at a position for placing each silicon substrate 51. Each holder 21 is formed of a conductive material such as silicon carbide (SiC) which is durable at elevated temperatures such as 1,000°C. When the holder 21 is composed of a material having an electric conductivity which is substantially the same as that of the silicon substrate 51, the holder 21 is heated together with the silicon substrate 51 without heat being dissipated from the silicon substrate 51. Thus, a state in which the silicon substrate 51 has a uniform temperature can be readily achieved.

When the silicon substrate 51 is circular, the diameter of the opening 22 formed in each holder 21 is several mm to ten and several mm shorter than the diameter of the silicon substrate 51. When the substrate is rectangular, the length is several mm to ten and several mm shorter than the length of the substrate, although this is not clearly indicated on the drawing.

The arrangement of the silicon substrates 51 is such that the vertical distance between the silicon substrates 51 is, for example, 1/2 or 1/4 of the wavelength of electromagnetic waves, or an integral multiple of the wavelength of the electromagnetic waves, in which case the distance would actually be 61 mm. The horizontal distance between the silicon substrates 51 is, for example, an integral multiple of the wavelength or 1/2 or 1/4 of the wavelength of the electromagnetic waves, in which case the distance would actually be 61 mm.

The silicon substrates 51 placed in the reaction chamber 11 are arrayed three-dimensionally in the first thermal CVD apparatus 1; hence the silicon substrates 51 are irradiated and heated with electromagnetic waves supplied from the electromagnetic wave generator 12. The electromagnetic waves scattered from the silicon substrates 51 are interfered to form a photonic band. Thus, electromagnetic waves are confined in the vicinity of the silicon substrates 51 to effectively heat the silicon substrates 51.

In the formation of the thin-film monocrystalline silicon in the first thermal CVD apparatus 1, the silicon substrate 51 is supported on each holder 21 in the reaction chamber 11 which is hated to an elevated temperature of approximately 1,000°C by electromagnetic waves supplied from the electromagnetic wave generator 12 while a silicon-containing compound is fed to the reaction chamber 11 through the gas supply pipe 13 so as to deposit silicon on the silicon substrate 51 by pyrolysis. As the silicon-containing compounds, gases, such as SiCl₄, SiHCl₃, SiH₂Cl₂, and SiH₄, are generally used. These gases are diluted with hydrogen gas and are fed into the reaction chamber 11, while the excess silicon-containing gas in the reaction chamber 11 is expelled through the gas exhaust pipes 14 provided on a side wall of the reaction chamber 11.

The first thermal CVD apparatus 1 does not require a susceptor, which is essential for holding the silicon substrates in conventional chemical vapor deposition apparatuses. Since energy required for heating the susceptor can be used for heating the silicon substrate, the energy can be more effectively used. Moreover, the holder 21 having the opening 22 is used instead of the susceptor. Thus, thin-film monocrystalline silicon can be simultaneously formed on the upper and lower faces of the silicon substrate 51, resulting in high volume efficiency.

In contrast, in other deposition apparatuses which place silicon substrates on susceptors, the front face of each silicon substrate is primarily cooled by a hydrogen carrier, resulting in deformation of the substrate. For example, a known hot wall apparatus of an induction heating system heats only the periphery of the silicon substrate by the skin effect; hence, a large temperature gradient occurs in the silicon substrate, causing deformation. The gradient results in stresses which induce slip defects.

The first thermal CVD apparatus 1, however, holds the silicon substrate 51 on the periphery of the opening 22 of the holder 21; hence, the two faces of the silicon substrate 51 are exposed. Since the two faces of the silicon substrate 51 are simultaneously heated by electromagnetic waves (for example, microwaves), only slight deformation occurs in the silicon substrate 51. Moreover, the faces of the silicon substrate 51 can be heated by electromagnetic waves with a uniform intensity distribution. Thus, high-quality thin-film monocrystalline silicon having fewer defects can be formed.

In an induction heating type CVD apparatus which has high volume efficiency by stacking silicon substrates as in the first thermal CVD apparatus 1, only the periphery of each silicon substrate is heated by the skin effect. Thus, a large temperature gradient occurs in the silicon substrate. Although this temperature gradient is moderated by thermal conduction of the silicon substrate and radiant heat from the silicon substrate, it takes too long to make the temperature of the silicon substrate uniform, thus the problem of reduced volume efficiency arises.

Since in the first thermal CVD apparatus 1, the silicon substrates 51 can be stacked on the holders 21, many silicon substrates 51 can be subjected to deposition simultaneously. Accordingly, this deposition apparatus has remarkably high volume efficiency.

The silicon substrate is held horizontally in this embodiment. Alternatively, the silicon substrate may be tilted at an appropriate angle by rotating the overall apparatus. When the silicon substrate is held perpendicularly, the formation of slip defects caused by flexure stress which occurs due to the weight of the silicon substrate is suppressed at elevated temperatures such as 1,000°C.

### Second Thermal CVD Apparatus

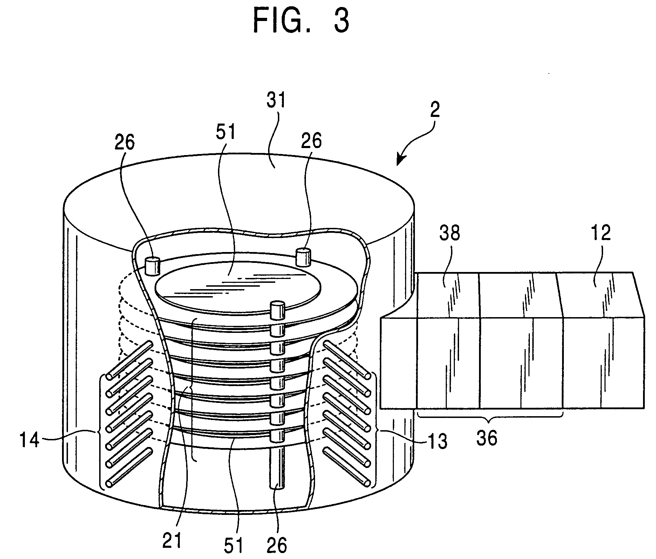

A first embodiment of the chemical vapor deposition apparatus according to a second aspect in accordance with the present invention (hereinafter referred to as a second thermal CVD apparatus) will be described with reference to Fig. 3 which is a partially cut-away view of an overall configuration thereof. The same components illustrated in the former embodiment are referred to as the same reference numerals.

The second thermal CVD apparatus heats the substrate (hereinafter referred to as a silicon substrate) to an elevated temperature of approximately 1,000°C and supplies a silicon-containing compound into the cavity resonator. Thin-film monocrystalline silicon is deposited on the silicon substrate by pyrolysis. In this embodiment, the reaction chamber 11 in the first thermal CVD apparatus 1 is replaced with a cylindrical cavity resonator.

With reference to Fig. 3, the second thermal CVD apparatus 2 is provided with a ring cavity resonator 31. The cavity resonator 31 is formed of, for example, aluminum, copper, or stainless steel having an electrical conductivity, which is higher than that of the silicon substrate 51. However, the use of the cavity resonator 31 of aluminum and copper restricts the types of gases used in the film deposition. That is, gases which do not contain corrosive components are used. The internal face of the cavity resonator 31 of aluminum or copper may be coated with gold. However, in a cavity resonator formed of stainless steel having high corrosion resistance, gold coating is unnecessary except that gas containing a component causing corrosion of stainless steel is used.

Holders 21 are arranged into a plurality of layers (for example, eight layers), each supporting a silicon substrate 51, in the interior of the cavity resonator 31. These holders 21 are supported by holder supporters 26 at a predetermined interval. In this embodiment, the silicon substrates 51 are unidimensionally arranged. Of course, the silicon substrates 51 may be arrayed two-dimensionally or three-dimensionally.

An electromagnetic wave generator 12 for supplying electromagnetic waves to the cavity resonator 31 via a waveguide 36 is connected to a side wall of the cavity resonator 31. This means the electromagnetic wave generator 12 is placed at the incident end of the waveguide 36. A magnetron is used, for example, as the electromagnetic wave generator 12. The oscillation frequency thereof is in the microwave or millimeter band. In this embodiment, 2.46 GHz microwaves, for example, are used. In order to prevent reflection of the electromagnetic waves towards the electromagnetic wave generator 12 as the electromagnetic wave source, the waveguide 36 connecting the electromagnetic wave generator 12 and the cavity resonator 31 is provided with an isolator 38.

A plurality of gas supply pipes 13 and a plurality of gas exhaust pipes 14 are connected to the side wall of the cavity resonator 31. It is preferable that the diameters of each gas supply pipe 13 and each gas exhaust pipe 14 be smaller than the wavelength of the electromagnetic waves in order to prevent leakage of the electromagnetic waves from the cavity resonator 31. The position of the connection of each pipe in the cavity resonator 31 preferably corresponds to a position of an antinode having a maximum amplitude of the standing wave of the electromagnetic waves, that is, a position with minimized current flow in the wall of the cavity resonator 31. Thus, each gas supply pipe 13 and each gas exhaust pipe 14 are connected at an intermediate height between the upper and lower silicon substrates 51 in the second thermal CVD apparatus 2. The diameters of each gas supply pipe 13 and each gas exhaust pipe 14 are, for example, 10 mm or less.

The holders 21 will be described. Each holder 21 is provided with an opening 22 at a position for placing the silicon substrate 51. Each holder 21 is formed of a conductive material such as silicon carbide (SiC) which is durable at elevated temperatures such as 1,000°C. When the holder 21 is composed of a material having an electric conductivity which is lower than that of the cavity resonator 31 and is substantially the same as that of silicon, the holder 21 is heated together with the silicon substrate 51 without heat being dissipated from the silicon substrate 51. Thus, a state in which the silicon substrate 51 has a uniform temperature can be readily achieved.

When the silicon substrate 51 is circular, the diameter of the opening 22 formed in each holder 21 is several mm to ten and several mm shorter than the diameter of the silicon substrate 51. When the substrate is rectangular, the length is several mm to ten and several mm shorter than the length of the substrate, although this is not clearly indicated on the drawing.

The arrangement of the silicon substrates 51 is such that the vertical distance between the silicon substrates 51 is, for example, 1/2 or 1/4 of the wavelength of electromagnetic waves, or an integral multiple of the wavelength of the electromagnetic waves, in which case the distance would actually be 61 mm. When the silicon substrates 51 are also arrayed in the horizontal direction, the horizontal distance between the silicon substrates 51 is, for example, an integral multiple of the wavelength or 1/2 or 1/4 of the wavelength of the electromagnetic waves.

The silicon substrates 51 placed in the reaction chamber 11 are arrayed three-dimensionally in the second thermal CVD apparatus 2; hence the silicon substrates 51 are irradiated and heated with electromagnetic waves supplied from the electromagnetic wave generator 12 via the waveguide 36. The electromagnetic waves leaked from the silicon substrates 51 are confined in the cavity resonator 31 and are used for heating the silicon substrates 51. Thus, electromagnetic waves are confined in the vicinity of the silicon substrates 51 to effectively heat the silicon substrates 51.

In order to prevent heating of the cavity resonator 31 by radiation from the silicon substrates 51 which are heated to an elevated temperature, the inner face of the cavity resonator 31 is polished so that the surface roughness is 1/10 or less the wavelength of the electromagnetic waves. Since the inner face of the cavity resonator 31 is polished, radiant waves are confined in the cavity resonator 31 and are used for heating the silicon substrates 51.

The resonance mode in the cavity resonator 31 is determined by the silicon substrates 51 and the cavity resonator 31. The electromagnetic waves induce a current I which flows in the silicon substrates 51 and the cavity resonator 31 and heats the silicon substrates 51 and the cavity resonator 31. Supposing the resistance is R, then the heat divergence is in proportion to RI². Thus, the heat divergence in the silicon substrates 51 is larger than that in the cavity resonator 31. As a result, the energy of the electromagnetic waves is effectively absorbed in the silicon of the silicon substrates 51 and is not substantially absorbed in the cavity resonator 31. Since the temperature of the cavity resonator 31 is not substantially elevated, amorphous silicon etc. is not substantially deposited on the side wall of the cavity resonator 31 during the film deposition.

In other methods for placing silicon substrates on susceptors, a face of each silicon substrate is cooled by primarily a hydrogen carrier, causing deformation of the silicon substrate. An induction heating type hot wall apparatus heats only the periphery of a silicon substrate by the skin effect; hence, the silicon substrate has a large temperature gradient which generates deformation. Moreover, the stress generated by the deformation induces slip defects. Since the holders 21 are used in the second thermal CVD apparatus 2 such that the two sides of each silicon substrate 51 are exposed on each holder, the two faces of the silicon substrate 51 are simultaneously cooled. Thus, deformation barely forms in the silicon substrate 51. Moreover, the faces of the silicon substrate 51 can be heated by electromagnetic waves with a uniform intensity distribution. Thus, high-quality thin-film monocrystalline silicon having fewer defects can be formed on the silicon substrate 51.

In the formation of the thin-film monocrystalline silicon in the second thermal CVD apparatus 2, the silicon substrate 51 is supported on each holder 21 in the cavity resonator 31 which is hated to an elevated temperature of approximately 1,000°C by electromagnetic waves supplied from the electromagnetic wave generator 12 while a silicon-containing compound is fed to the reaction chamber 11 through the gas supply pipe 13 so as to deposit silicon on the silicon substrate 51 by pyrolysis. As the silicon-containing compounds, gases, such as SiCl₄, SiHCl₃, SiH₂Cl₂, and SiH₄, are generally used. These gases are diluted with hydrogen gas and are fed into the cavity resonator 31, while the excess silicon-containing gas in the cavity resonator 31 is expelled through the gas exhaust pipes 14 provided on a side wall of the cavity resonator 31.

It is preferable that the diameters of each gas supply pipe 13 and each gas exhaust pipe 14 be smaller than the wavelength of the electromagnetic waves in order to prevent leakage of the electromagnetic waves. The positions of the connections of each gas supply pipe 13 and each gas exhaust pipe 14 in the cavity resonator 31 preferably correspond to the position of an antinode having a maximum amplitude of the standing wave of the electromagnetic waves, that is, positions showing a minimized current flow in the wall of the cavity resonator 31. Thus, each gas supply pipe 13 and each gas exhaust pipe 14 are connected at an intermediate height between the upper and lower silicon substrates 51 in the second thermal CVD apparatus 2. The diameters of each gas supply pipe 13 and each gas exhaust pipe 14 are, for example, 10 mm or less.

The second thermal CVD apparatus 2 does not require a susceptor, which is essential for holding the silicon substrates in conventional chemical vapor deposition apparatuses. Since energy required for heating the susceptor can be used for heating the silicon substrate, the energy can be more effectively used. Moreover, the holder 21 having the opening 22 is used instead of the susceptor. Thus, thin-film monocrystalline silicon can be simultaneously formed on the upper and lower faces of the silicon substrate 51, resulting in high volume efficiency.

Meanwhile, an induction heating type CVD apparatus having high volume efficiency by stacking silicon substrates as in the second thermal CVD apparatus 2, the silicon substrates have large temperature gradients since only the peripheries thereof are heated by the skin effect. Although this temperature gradient is moderated by thermal conduction of the silicon substrate and radiant heat from the silicon substrate, it takes too long to make the temperature of the silicon substrate uniform, thus the problem of reduced volume efficiency arises.

The second thermal CVD apparatus 2, however, holds the silicon substrate 51 on the periphery of the opening 22 of the holder 21; hence, the two faces of the silicon substrate 51 are exposed. Since the two faces of the silicon substrate 51 are simultaneously heated by electromagnetic waves (for example, microwaves), only slight deformation occurs in the silicon substrate 51. Moreover, the faces of the silicon substrate 51 can be heated by electromagnetic waves with a uniform intensity distribution. Thus, high-quality thin-film monocrystalline silicon having fewer defects can be formed.

Since in the above second thermal CVD apparatus 2, the silicon substrates 51 are stacked on the holders 21, many silicon substrates 51 can be simultaneously subjected to deposition. Thus, the deposition apparatus has high volume efficiency.

The use of a material, having a resistivity which is smaller than that of the silicon substrate 51, in the cavity resonator 31 enables effective heating of the silicon substrate 51 without substantially heating the cavity resonator 31. Thus, the silicon substrate 51 can be heated using less energy.

In the cavity resonator 31 formed of a material having high reflectance for radiation (mainly infrared rays) from the heated silicon substrates 51, the radiation from the silicon substrates 51 can be effectively confined in the cavity resonator 31. Since the confined radiation is thereby used for heating the silicon substrates 51, the utilization efficiency of energy is enhanced.

The silicon substrate is held horizontally in this embodiment. Alternatively, the silicon substrate may be tilted at an appropriate angle by rotating the overall apparatus. When the silicon substrate is held perpendicularly, the formation of slip defects caused by flexure stress which occurs due to the weight of the silicon substrate is suppressed at elevated temperatures such as 1,000°C.

### Third Thermal CVD Apparatus

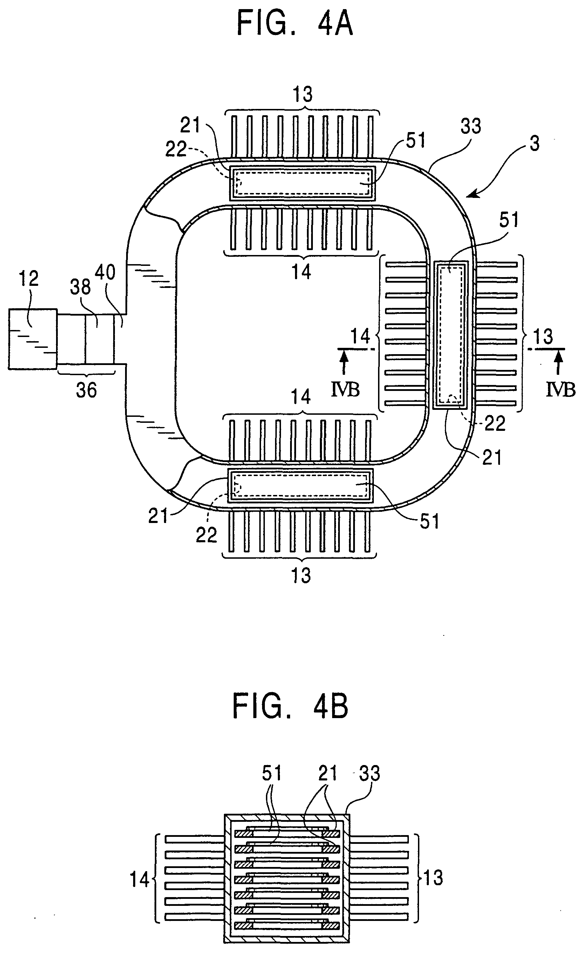

A second embodiment of the chemical vapor deposition apparatus according to the second aspect in accordance with the present invention (hereinafter referred to as a third thermal CVD apparatus) will be described with reference to Fig. 4A which is a partially cut-away cross-sectional view of an overall configuration thereof and Fig. 4B which is an enlarged cross-sectional view taken from line IVB-IVB in Fig. 4A. The same components illustrated in the former embodiments are referred to using the same reference numerals.

The third thermal CVD apparatus heats the substrate (hereinafter referred to as a silicon substrate) to an elevated temperature of approximately 1,000°C and supplies a silicon-containing compound into the cavity resonator. Thin-film monocrystalline silicon is deposited on the silicon substrate by pyrolysis. In this embodiment, the cavity resonator is of a ring type, and the ring cavity resonator is connected to a waveguide with a T-shaped coupler to transmit the electromagnetic waves to the ring cavity resonator.

With reference to Fig. 4A, the third thermal CVD apparatus 3 is provided with a ring cavity resonator 33. The ring cavity resonator 33 is formed of, for example, aluminum, copper, or stainless steel, which has an electrical conductivity higher than that of the silicon substrate 51. However, the ring cavity resonator 33 of aluminum and copper restricts the types of gases used in the film deposition. That is, gases which do not contain corrosive components are used. Thus, in the ring cavity resonator 33 of aluminum or copper, the internal face thereof is coated with gold. However, in a ring cavity resonator formed of stainless steel having high corrosion resistance, gold coating is unnecessary except that gas containing a component causing corrosion of stainless steel is used.

Holders 21 are arranged at a plurality of places (for example, three places) into a plurality of layers (for example, seven layers), each supporting a silicon substrate 51, in the interior of the ring cavity resonator 33. These holders 21 are supported by holder supporters (not shown in the drawings) at a predetermined interval. In this embodiment, the silicon substrates 51 are rectangular and are unidimensionally arranged in one holder group. Of course, the silicon substrates 51 may be arrayed two-dimensionally or three-dimensionally in the same holder group.

The output end of the waveguide 36 is connected to a side wall of the ring cavity resonator 33 with the T-shaped coupler 40 while the input end of the waveguide 36 is connected to an electromagnetic wave generator 12 for supplying electromagnetic waves to the ring cavity resonator 33. A magnetron is used, for example, as the electromagnetic wave generator 12. The oscillation frequency thereof is in the microwave or millimeter band. In this embodiment, 2.46 GHz microwaves, for example, are used. In order to prevent reflection of the electromagnetic waves from the ring cavity resonator 33 to the electromagnetic wave generator 12 as the electromagnetic wave source, the waveguide 36 is provided with an isolator 38.

A plurality of gas supply pipes 13 is connected to a side wall of the ring cavity resonator 33 at the position of each holder group including a plurality of stacked holders 21, whereas a plurality of gas exhaust pipes 14 is connected to another side wall of the ring cavity resonator 33 at the position opposing the plurality of gas supply pipes 13.

It is preferable that the diameters of each gas supply pipe 13 and each gas exhaust pipe 14 be smaller than the wavelength of the electromagnetic waves in order to prevent leakage of the electromagnetic waves from the ring cavity resonator 33. The position of the connection in the ring cavity resonator 33 preferably corresponds to the position of an antinode having a maximum amplitude of the standing wave of the electromagnetic waves, that is, a position showing a minimized current flow in the wall of the ring cavity resonator 33. Thus, each gas supply pipe 13 and each gas exhaust pipe 14 are connected at an intermediate height between the upper and lower silicon substrates 51 in this third thermal CVD apparatus 3. The diameters of each gas supply pipe 13 and each gas exhaust pipe 14 are, for example, 10 mm or less. The position of each silicon substrate 51 and the positions of each gas supply pipe 13 and each gas exhaust pipe 14 may have an appropriate angle to the central axis of the waveguide 36.

The silicon substrate is held horizontally in this embodiment. Alternatively, the silicon substrate may be tilted at an appropriate angle by rotating the overall apparatus. When the silicon substrate is held perpendicularly, the formation of slip defects caused by flexure stress which occurs due to the weight of the silicon substrate is suppressed at elevated temperatures such as 1,000°C.

The holders 21 will be described. Each holder 21 is provided with an opening 22 at a position for placing the silicon substrate 51. Each holder 21 is formed of a conductive material such as silicon carbide (SiC) which is durable at elevated temperatures such as 1,000°C. When the holder 21 is composed of a material having an electric conductivity which is lower than that of the ring cavity resonator 33 and is substantially the same as that of silicon, the holder 21 is heated together with the silicon substrate 51 without heat being dissipated from the silicon substrate 51. Thus, a state in which the silicon substrate 51 has a uniform temperature can be readily achieved.

When the silicon substrate 51 is circular, the diameter of the opening 22 formed in each holder 21 is several mm to ten and several mm shorter than the diameter of the silicon substrate 51. When the substrate is rectangular, the length is several mm to ten and several mm shorter than the length of the substrate, although this is not clearly indicated on the drawing.

The arrangement of the silicon substrates 51 is such that the vertical distance between the silicon substrates 51 is, for example, 1/2 or 1/4 of the wavelength of electromagnetic waves, or an integral multiple of the wavelength of the electromagnetic waves, in which case the distance would actually be 61 mm. When the silicon substrates 51 are also arrayed in the horizontal direction, the horizontal distance between the silicon substrates 51 is, for example, an integral multiple of the wavelength or 1/2 or 1/4 of the wavelength of the electromagnetic waves.

In order to prevent heating of the ring cavity resonator 33 by radiation from the silicon substrates 51 which are heated to an elevated temperature, the inner face of the ring cavity resonator 33 is polished so that the surface roughness is 1/10 or less the wavelength of the electromagnetic waves. Since the inner face of the ring cavity resonator 33 is polished, radiant waves are confined in the ring cavity resonator 33 and are used for heating the silicon substrates 51.

The resonance mode in the ring cavity resonator 33 is determined by the silicon substrates 51 and the ring cavity resonator 33. The electromagnetic waves induce a current I which flows in the silicon substrates 51 and the ring cavity resonator 33, and heats the silicon substrates 51 and the ring cavity resonator 33. Supposing the resistance is R, then the heat divergence is in proportion to RI². Thus, the heat divergence in the silicon substrates 51 is larger than that in the ring cavity resonator 33. As a result, the energy of the electromagnetic waves is effectively absorbed in the silicon of the silicon substrates 51 and is not substantially absorbed in the ring cavity resonator 33. Since the temperature of the ring cavity resonator 33 is not substantially elevated, amorphous silicon etc. is not substantially deposited on the side walls of the ring cavity resonator 33 during the film deposition.

In the formation of the thin-film monocrystalline silicon in the third thermal CVD apparatus 3, the silicon substrate 51 is supported on each holder 21 in the ring cavity resonator 33 which is hated to an elevated temperature of approximately 1,000°C by electromagnetic waves supplied from the electromagnetic wave generator 12 while a silicon-containing compound is fed to the reaction chamber 11 through the gas supply pipe 13 so as to deposit silicon on the silicon substrate 51 by pyrolysis. As the silicon-containing compounds, gases, such as SiCl₄, SiHCl₃, SiH₂Cl₂, and SiH₄, are generally used. These gases are diluted with hydrogen gas and are fed into the ring cavity resonator 33, while the excess silicon-containing gas in the ring cavity resonator 33 is expelled through the gas exhaust pipes 14 provided on a side wall of the cavity resonator 33.

It is preferable that the diameters of each gas supply pipe 13 and each gas exhaust pipe 14 be smaller than the wavelength of the electromagnetic waves in order to prevent leakage of the electromagnetic waves. The positions of the connections of each gas supply pipe 13 and each gas exhaust pipe 14 in the ring cavity resonator 33 preferably correspond to the position of an antinode having a maximum amplitude of the standing wave of the electromagnetic waves, that is, positions showing a minimized current flow in the wall of the ring cavity resonator 33. Thus, each gas supply pipe 13 and each gas exhaust pipe 14 are connected at an intermediate height between the upper and lower silicon substrates 51 in the third thermal CVD apparatus 3. The diameters of each gas supply pipe 13 and each gas exhaust pipe 14 are, for example, 10 mm or less.

The gas supplied through these gas supply pipes 13 flows as layered streams between the silicon substrates 51 and is pyrolyzed on the silicon substrates 51 to form thin-film monocrystalline silicon. In this third thermal CVD apparatus 3, the gas flows in the direction perpendicular to the arrangement or the longitudinal direction of the substrate, instead of a flow in the direction of the arrangement or the longitudinal direction of the substrate, as in a transverse epitaxial deposition apparatus; hence, thin-film monocrystalline silicon having a uniform thickness is readily obtainable. By depositing the film by reversing the directions of the inlet and outlet of the gas, the resulting thin-film monocrystalline silicon has a more uniform thickness.

The third thermal CVD apparatus 3 does not require a susceptor, which is essential for any conventional chemical vapor deposition apparatus. Since energy required for heating the susceptor can be used for heating the silicon substrate, the energy can be more effectively used. Moreover, the holder 21 having the opening 22 is used instead of the susceptor. Thus, thin-film monocrystalline silicon can be formed simultaneously on the upper and lower faces of the silicon substrate 51, resulting in high volume efficiency, as in the above embodiments.

### Fourth Thermal CVD Apparatus

A third embodiment of the chemical vapor deposition apparatus according to the second aspect in accordance with the present invention (hereinafter referred to as a fourth thermal CVD apparatus) will be described with reference to Fig. 4 which is a partially cut-away cross-sectional view of an overall configuration thereof. The same components illustrated in the former embodiments are referred to using the same reference numerals. This chemical vapor deposition apparatus also includes a ring cavity resonator, as in the third thermal CVD apparatus 3.

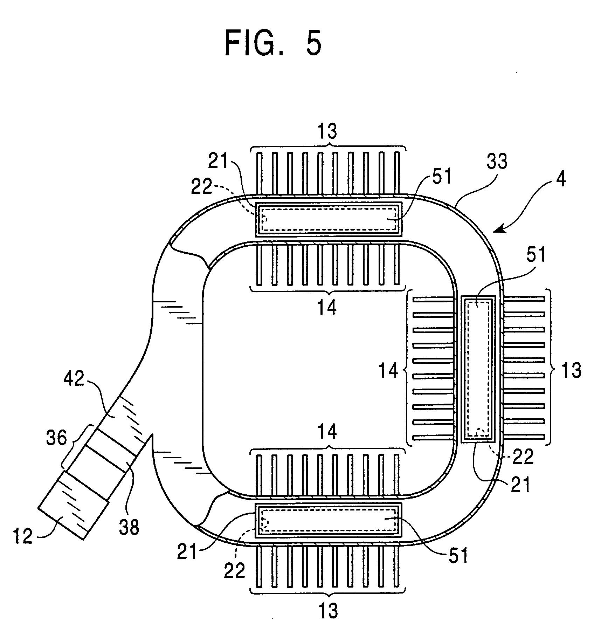

With reference to Fig. 5, the fourth thermal CVD apparatus 4 has a waveguide 36 connected to a ring cavity resonator 33 with a directional coupler 42 which is used instead of the T-shaped coupler 40 used in the third thermal CVD apparatus 3. The directional coupler 42 transmits electromagnetic waves to a ring cavity resonator 33. The T-shaped coupler 40 guides electromagnetic waves both in the right and left directions of the ring cavity resonator 33 in the third thermal CVD apparatus 3, whereas the directional coupler 42 guides electromagnetic waves only in one direction in the fourth thermal CVD apparatus 4. The other components, such as the electromagnetic wave generator 12, the isolator 38, the holder 21, the holder support (not shown in the drawing), the gas supply pipes 13, and the gas exhaust pipes 14, are the same as those in the third thermal CVD apparatus 3.

The fourth thermal CVD apparatus 4 is provided with a ring cavity resonator 33. The ring cavity resonator 33 is formed of, for example, aluminum, copper, or stainless steel, which has an electrical conductivity higher than that of the silicon substrate 51. However, the ring cavity resonator 33 of aluminum and copper restricts the types of gases used in the film deposition. That is, gases which do not contain corrosive components are used. Thus, in the ring cavity resonator 33 of aluminum or copper, the internal face thereof is coated with gold. However, in a ring cavity resonator formed of stainless steel having high corrosion resistance, gold coating is unnecessary except that gas containing a component causing corrosion of stainless steel is used.

Holders 21 are arranged at a plurality of places (for example, three places) into a plurality of layers (for example, seven layers), each supporting a silicon substrate 51, in the interior of the ring cavity resonator 33. These holders 21 are supported by holder supporters (not shown in the drawings) at a predetermined interval. In this embodiment, the silicon substrates 51 are rectangular and are unidimensionally arranged in one holder group. Of course, the silicon substrates 51 may be arrayed two-dimensionally or three-dimensionally in the same holder group.

An electromagnetic wave generator 12 is connected to a side wall of the ring cavity resonator 33 for generating electromagnetic waves to the ring cavity resonator 33 via the directional coupler 42 and a waveguide 36. That is, the electromagnetic wave generator 12 is placed at the incident end of the waveguide 36. A magnetron is used, for example, as the electromagnetic wave generator 12. The oscillation frequency thereof is in the microwave or millimeter band. In this embodiment, 2.46 GHz microwaves, for example, are used. In order to prevent reflection of the electromagnetic waves from the ring cavity resonator 33 to the electromagnetic wave generator 12 as the electromagnetic wave source, the waveguide 36 is provided with an isolator 38.

A plurality of gas supply pipes 13 is connected to a side wall of the ring cavity resonator 33 at the position of each holder group including a plurality of stacked holders 21, whereas a plurality of gas exhaust pipes 14 is connected to another side wall of the ring cavity resonator 33 at the position opposing the plurality of gas supply pipes 13.

It is preferable that the diameters of each gas supply pipe 13 and each gas exhaust pipe 14 be smaller than the wavelength of the electromagnetic waves in order to prevent leakage of the electromagnetic waves from the ring cavity resonator 33. The position of the connection in the ring cavity resonator 33 preferably corresponds to the position of an antinode having a maximum amplitude of the standing wave of the electromagnetic waves, that is, a position with minimized current flow in the wall of the ring cavity resonator 33. Thus, each gas supply pipe 13 and each gas exhaust pipe 14 are connected at an intermediate height between the upper and lower silicon substrates 51 in this third thermal CVD apparatus 3. The diameters of each gas supply pipe 13 and each gas exhaust pipe 14 are, for example, 10 mm or less. The position of each silicon substrate 51 and the positions of each gas supply pipe 13 and each gas exhaust pipe 14 may have an appropriate angle to the central axis of the waveguide 36.

The silicon substrate is held horizontally in this embodiment. Alternatively, the silicon substrate may be tilted at an appropriate angle by rotating the overall apparatus. When the silicon substrate is held perpendicularly, the formation of slip defects caused by flexure stress which occurs due to the weight of the silicon substrate is suppressed at elevated temperatures such as 1,000°C.

The holders 21 will be described. Each holder 21 is provided with an opening 22 at a position for placing the silicon substrate 51. Each holder 21 is formed of a conductive material such as silicon carbide (SiC) which is durable at elevated temperatures such as 1,000°C. When the holder 21 is composed of a material having an electric conductivity which is lower than that of the ring cavity resonator 33 and is substantially the same as that of silicon, the holder 21 is heated together with the silicon substrate 51 without heat being dissipated from the silicon substrate 51. Thus, a state in which the silicon substrate 51 has a uniform temperature can be readily achieved.

When the silicon substrate 51 is circular, the diameter of the opening 22 formed in each holder 21 is several mm to ten and several mm shorter than the diameter of the silicon substrate 51. When the substrate is rectangular, the length is several mm to ten and several mm shorter than the length of the substrate.

The arrangement of the silicon substrates 51 is such that the vertical distance between the silicon substrates 51 is, for example, 1/2 or 1/4 of the wavelength of electromagnetic waves, or an integral multiple of the wavelength of the electromagnetic waves, in which case the distance would actually be 61 mm. When the silicon substrates 51 are also arrayed in the horizontal direction, the horizontal distance between the silicon substrates 51 is, for example, an integral multiple of the wavelength or 1/2 or 1/4 of the wavelength of the electromagnetic waves.

In order to prevent heating of the ring cavity resonator 33 by radiation from the silicon substrates 51 which are heated to an elevated temperature, the inner face of the ring cavity resonator 33 is polished so that the surface roughness is 1/10 or less the wavelength of the electromagnetic waves. Since the inner face of the ring cavity resonator 33 is polished, radiation is confined in the ring cavity resonator 33 and are used for heating the silicon substrates 51.

The resonance mode in the ring cavity resonator 33 is determined by the silicon substrates 51 and the ring cavity resonator 33. The electromagnetic waves induce a current I which flows in the silicon substrates 51 and the ring cavity resonator 33 and heats the silicon substrates 51 and the ring cavity resonator 33. Supposing the resistance is R, then the heat divergence is in proportion to RI². Thus, the heat divergence in the silicon substrates 51 is larger than that in the ring cavity resonator 33. As a result, the energy of the electromagnetic waves is effectively absorbed in the silicon of the silicon substrates 51 and is not substantially absorbed in the ring cavity resonator 33. Since the temperature of the ring cavity resonator 33 is not substantially elevated, amorphous silicon etc. is not substantially deposited on the side walls of the ring cavity resonator 33 during the film deposition.

In the formation of the thin-film monocrystalline silicon in the fourth thermal CVD apparatus 4, the electromagnetic waves generated by the electromagnetic wave generator 12 are introduced in one direction through the directional coupler 42, and the silicon substrates 51 supported on the holders 21 in the ring cavity resonator 33 are hated to an elevated temperature of approximately 1,000°C. In this state, a silicon-containing compound is fed to the reaction chamber 11 through the gas supply pipes 13 so as to deposit silicon on the silicon substrates 51 by pyrolysis. As the silicon-containing compounds, gases, such as SiCl₄, SiHCl₃ SiH₂Cl₂, and SiH₄, are generally used. These gases are diluted with hydrogen gas and are fed into the ring cavity resonator 33, while the excess silicon-containing gas in the ring cavity resonator 33 is expelled of through the gas exhaust pipes 14 provided on a side wall of the cavity resonator 33.

The gas supplied through these gas supply pipes 13 flows as layered streams between the silicon substrates 51 and is pyrolyzed on the silicon substrates 51 to form thin-film monocrystalline silicon. In this fourth thermal CVD apparatus 4, the gas flows in the direction perpendicular to the arrangement or the longitudinal direction of the substrate, instead of a flow in the direction of the arrangement or the longitudinal direction of the substrate, as in a transverse epitaxial deposition apparatus; hence, thin-film monocrystalline silicon having a uniform thickness is readily obtainable. By depositing the film by reversing the directions of the inlet and outlet of the gas, the resulting thin-film monocrystalline silicon has a more uniform thickness.

A susceptor, which is essential in conventional chemical vapor deposition apparatuses is not required in the fourth thermal CVD apparatus 4. Since energy required for heating the susceptor can be used for heating the silicon substrate, the energy can be more effectively used. Moreover, the holder 21 having the opening 22 is used instead of the susceptor. Thus, thin-film monocrystalline silicon can be simultaneously formed on the upper and lower faces of the silicon substrate 51, resulting in high volume efficiency, as in the above second thermal CVD apparatus 2.

### Fifth Thermal CVD Apparatus

A fourth embodiment of the chemical vapor deposition apparatus according to the second aspect in accordance with the present invention (hereinafter referred to as a fifth thermal CVD apparatus) will be described.

The basic configuration of the fifth thermal CVD apparatus is the same as that of the above fourth thermal CVD apparatus 4. In this fifth thermal CVD apparatus, the ring cavity resonator 33 is designed so that the resonant mode slightly shifts, for example, by 0.001% to 1% to the incident electromagnetic waves. Thus, the electromagnetic waves in the ring cavity resonator 33 are not standing waves but are propagating waves. Since the heat divergence distribution on the silicon substrate 51 becomes more uniform in this apparatus compared to the above fourth thermal CVD apparatus 4, the temperature distribution on the silicon substrate 51 becomes uniform in a short time.

The ring cavity resonator 33 is heated by not only electromagnetic waves but also by radiation from the heated silicon substrate 51. Thus, a rise in temperature due to radiant heat can be suppressed by heating the silicon substrate 51 in a short time, maintaining the ring cavity resonator 33 at low temperature. As a result, energy supplied as electromagnetic waves is more effectively used for heating the ring cavity resonator 33. Since pyrolytic deposition of the silicon material on the walls of the ring cavity resonator 33 is reduced, the silicon material is more effectively deposited on the substrate 51.

Such a ring cavity resonator 33 having a resonant mode which slightly shifts, for example, by 0.001% to 1% is also applicable to other cavity resonators in the first thermal CVD apparatus 1 and the second thermal CVD apparatus 2.

### Modification of First to Fourth Thermal CVD Apparatuses

### (Sixth Thermal CVD Apparatus)

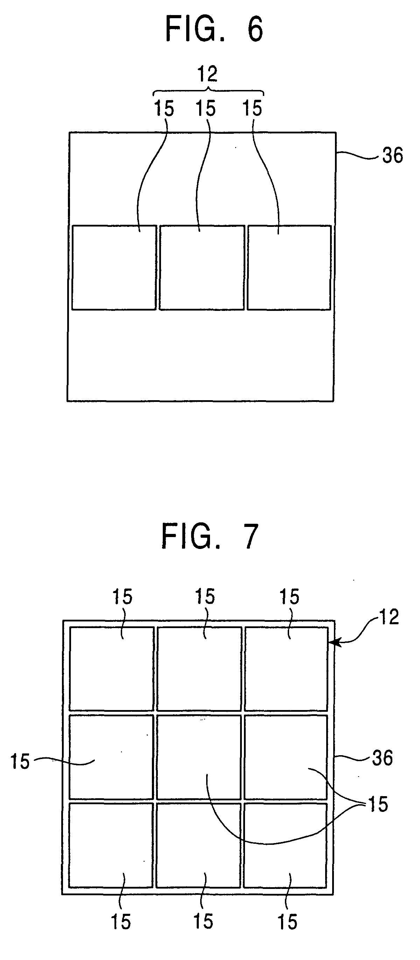

A modification of the electromagnetic wave generator 12 in accordance with the first to fourth thermal CVD apparatuses 1 to 4 will be described with reference to Fig. 6. The same components illustrated in the former embodiments are referred to using the same reference numerals.

The electromagnetic wave source of the electromagnetic wave generator 12 is replaced with oscillators 15 which are linearly arranged on a plane parallel to a silicon substrate (not shown in the drawing). Each oscillator 15 consists of an independent magnetron. The frame represents a waveguide 36.

Electromagnetic waves emitted from these oscillators 15 heat silicon substrates as in the fifth thermal CVD apparatus. Since frequencies thereof are slightly different from each other, the intensity distribution changes over time due to the formation of the interference beat. However, the mode in the direction perpendicular to the silicon substrates is the same as that in the fifth thermal CVD apparatus. Since the time required for heating the silicon substrates is significantly longer than the beat period, the changes in electromagnetic waves are averaged so that the intensity distribution becomes uniform. Thus, a sixth thermal CVD apparatus provided with the electromagnetic wave generator shown in Fig. 6 can heat the silicon substrates in a shorter time than the fifth thermal CVD apparatus. Accordingly, the sixth thermal CVD apparatus utilizes energy and a silicon material more effectively.

Another feature of the sixth thermal CVD apparatus is that the mode in the direction perpendicular to the silicon substrates is the same as that in the fifth thermal CVD apparatus. Thus, leakage of electromagnetic waves from the ring cavity resonator can be reduced by providing holes at an intermediate height between the silicon substrates, as in the third and fourth thermal CVD apparatuses 3 and 4, respectively.

### Modification of First to Fourth Thermal CVD Apparatuses

### (Seventh Thermal CVD Apparatus)

Another modification of the electromagnetic wave generator 12 in accordance with the first to fourth thermal CVD apparatuses 1 to 4 will be described with reference to Fig. 7. The same components illustrated in the former embodiments are referred to using the same reference numerals.

The electromagnetic wave source of the electromagnetic wave generator 12 is replaced with a plurality of oscillators 15 which is two-dimensionally arranged. Each oscillator 15 consists of an independent magnetron. The frame represents a waveguide 36.

Electromagnetic waves emitted from the plurality of oscillators 15 heat silicon substrates as in the fifth thermal CVD apparatus. Since frequencies thereof are slightly different between the oscillators 15, the intensity distribution changes over time due to the formation of interference beat. A seventh thermal CVD apparatus provided with the electromagnetic wave generator shown in Fig. 7 (the basic configurations other than the electromagnetic wave generator are the same as those of the fifth thermal CVD apparatus) differs from the sixth CVD apparatus in that the mode in the direction perpendicular to the silicon substrates is not the standing wave which is the mode in the fifth thermal CVD apparatus. However, the silicon substrates can be more uniformly heated by averaging the electromagnetic waves by increasing the number of the oscillators 15 (magnetrons). Since more oscillators 15 (magnetrons) compared with the sixth thermal CVD apparatus are used, heating is performed with higher energy. Since the time required for heating the silicon substrates is significantly longer than the beat period, the changes in electromagnetic waves are averaged so that the intensity distribution becomes uniform. Accordingly, in the seventh thermal CVD apparatus, the silicon substrates can be heated within a further decreased time compared with the sixth thermal CVD apparatus. As a result, this apparatus utilizes energy and the silicon material more effectively.

However, the mode in the direction perpendicular to the silicon substrates is not the standing wave mode in this seventh thermal CVD apparatus. Thus, leakage of electromagnetic waves from the cavity resonator does not attenuate even when a hole is provided at an intermediate height between the silicon substrates. Thus, the diameter of the gas supply pipe and the diameter of the gas exhaust pipe must be sufficiently smaller than the wavelengths of the electromagnetic waves. For example, these are 1/10 or less of the wavelengths of the electromagnetic waves.

### Eighth Thermal CVD Apparatus

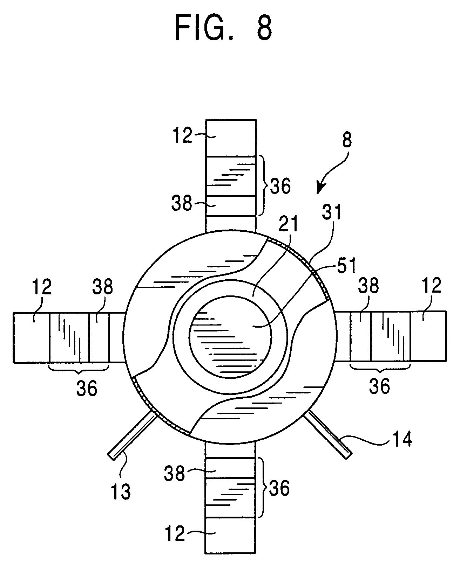

An eighth thermal CVD apparatus according to the second aspect in accordance with the present invention will be described with reference to Fig. 8 which is a partially cut-away cross-sectional view of an overall configuration thereof. The same components illustrated in the former embodiments are referred to using the same reference numerals.

This eighth thermal CVD apparatus 8 corresponds to a modification of the second thermal CVD apparatus 2 and is provided with a plurality of waveguides 36 (for example, four) for introducing electromagnetic waves into the cavity resonator 31. Electromagnetic waves are supplied from independent electromagnetic wave generators 12 to these waveguides 36. In order to prevent reflection of the electromagnetic waves from the cavity resonator 31 to the electromagnetic wave generators 12 as the electromagnetic wave sources, an isolator 38 is connected to each waveguide 36 which connects the corresponding electromagnetic wave generator 12 and the cavity resonator 31. A radial arrangement of the waveguides 36 from the cavity resonator 31 heats each substrate 51 with a uniform temperature distribution. Since many electromagnetic wave generators 12 (magnetrons) are connected, the electromagnetic wave energy required for heating increases. As a result, the temperature distribution in the silicon substrate 51 held by the holder 21 will become uniform in a short time. Thus, this apparatus utilizes the energy and the silicon material more effectively.

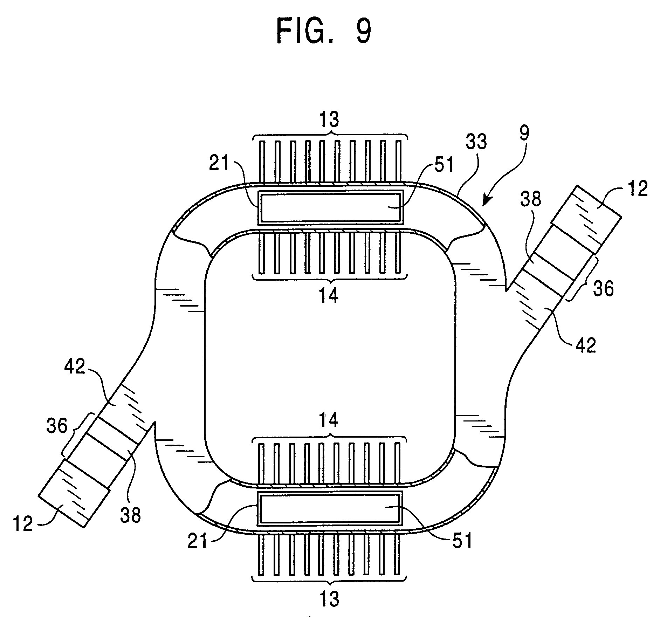

A ninth thermal CVD apparatus according to the second aspect in accordance with the present invention will be described with reference to Fig. 9 which is a partially cut-away cross-sectional view of an overall configuration thereof. The same components illustrated in the former embodiments are referred to using the same reference numerals.

The ninth thermal CVD apparatus 9 is provided with the ring cavity resonator 33 used in the fourth thermal CVD apparatus 4 and a plurality of waveguides 36 (for example, two) for introducing electromagnetic waves into the ring cavity resonator 33. The ring cavity resonator 33 and each waveguide 36 are connected with a unidirectional coupler 42.

The electromagnetic waves are absorbed and attenuated by the silicon substrates 51 held on the holders 21 in the ring cavity resonator 33. The introduction of electromagnetic waves from the plurality of waveguides 36 compensates for this attenuation. Thus, the temperature distribution in the ring cavity resonator 33 becomes uniform. Moreover, the plurality of electromagnetic wave generators 12 (for example, two) heat the substrates 51 with increased energy. Accordingly, in the ninth thermal CVD apparatus 9, the time required for heating the silicon substrates 51 is reduced compared with the fourth thermal CVD apparatus 4. As a result, the apparatus utilizes energy and the silicon material more effectively.

Each electromagnetic wave generator 12 of the ninth thermal CVD apparatus 9 preferably consists of a plurality of oscillators 15, as shown in Figs. 6 and 7. The gas supply pipes 13, the gas exhaust pipes 14, and the holders 21 are the same as those in the third thermal CVD apparatus 3.

### Tenth Thermal CVD Apparatus

A tenth thermal CVD apparatus according to the second aspect in accordance with the present invention will be described. The same components illustrated in the former embodiments are referred to using the same reference numerals.

In the tenth thermal CVD apparatus, the holder 21 for holding the silicon substrate 51 is composed of an insulating material in the configuration shown in the second thermal CVD apparatus 2. When the holder 21 does not come into close contact with the silicon substrate 51 in the second thermal CVD apparatus 2, the contact resistance may significantly increase. Thus, large heat dissipation may occur at the point of the contact between the holder 21 and the silicon substrate 51. In such a case, the uniformity of the temperature of the silicon substrate 51 may decrease. The insulating holder 21 solves the heat dissipation caused by the contact resistance. This insulating holder 21 is also applicable to the ring cavity resonator 33 described in the third to fifth thermal CVD apparatuses 3 to 5.

### Eleventh Thermal CVD Apparatus

An eleventh thermal CVD apparatus according to the second aspect in accordance with the present invention will be described. The same components illustrated in the former embodiments are referred to using the same reference numerals.

In the eleventh thermal CVD apparatus (see Fig. 3), the holder 21 for holding the silicon substrate 51, as well as the cavity resonator 31, is composed of a material having low electrical resistance in the configuration shown in the second thermal CVD apparatus 2. Since the holder 21 is formed of an insulating material in the tenth thermal CVD apparatus, the propagation mode of the electromagnetic waves may become unstable at the edge of the silicon substrate 51. In the eleventh thermal CVD apparatus, the propagation mode is stabilized; hence, the intensity of the electromagnetic waves on the silicon substrate 51 is constant. Thus, the temperature distribution on the silicon substrate 51 is uniform. This holder 21 is also applicable to the above ring cavity resonator 33.

### Twelfth Thermal CVD Apparatus

A twelfth thermal CVD apparatus according to the second aspect in accordance with the present invention will be described. The same components illustrated in the former embodiments are referred to using the same reference numerals.

In the twelfth thermal CVD apparatus (see Fig. 3), a reaction chamber 11 formed of synthetic quartz is placed in the cavity resonator 31 of the second thermal CVD apparatus 2. Although highly reactive silicon-containing gas corrodes the metal of the cavity resonator 31, the synthetic quartz reaction chamber 11 is resistive to corrosion by the gas. Such a configuration is also applicable to the eighth thermal CVD apparatus 8.

The first thermal CVD apparatus 1 is not limited to the above-mentioned configuration, as long as the silicon substrate 51 and the holder 21 are arranged so that the electromagnetic waves generated by the electromagnetic wave generator 12 are confined in the structure constituted by the silicon substrate 51 and the holder 21. The thermal CVD apparatus provided with the cavity resonator 31 or the ring cavity resonator 33 is not limited to the above-described configurations, as long as the silicon substrate 51 and the holder 21 are arranged so that the electromagnetic waves generated by the electromagnetic wave generator 12 are confined in the structure constituted by the silicon substrate 51, the holder 21, and the cavity resonator 31 or the ring cavity resonator 33.

The above embodiments involve the use of the silicon substrate. However, the substrate is not limited to the silicon substrate and may be an insulating substrate, such as a glass substrate or a ceramic substrate, or a semiconductor substrate. Moreover, the substrate may be provided with a thin film thereon.

The holder 21 may have a step along the periphery of the opening 22 for fitting the silicon substrate 51. When the substrate is placed on the holder having the step, the silicon substrate 51 fits into the step and is firmly held on the holder 21. Thus, the positioning of the silicon substrate 51 to the holder 21 is easy and the silicon substrate 51 is stably held on the holder 21.

## Claims

1. A chemical vapor deposition apparatus comprising:
a reaction chamber for forming a thin film on a face of a substrate placed therein; and
a substrate heater having an electromagnetic wave generator connecting to the reaction chamber for supplying electromagnetic waves to the reaction chamber.

2. A chemical vapor deposition apparatus according to claim 1, further comprising a holder for holding the substrate in the reaction chamber, the holder having an opening in the region the substrate is placed.

3. A chemical vapor deposition apparatus according to claim 2, wherein the substrate and the holder are arranged such that a structure constituted by the substrate and the holder confines the electromagnetic waves.

4. A chemical vapor deposition apparatus according to claim 1, wherein the electromagnetic wave generator comprises a plurality of independent electromagnetic wave generating units.

5. A chemical vapor deposition apparatus according to claim 4, wherein the plurality of electromagnetic wave generating units are linearly arranged parallel to the plane of the substrate.

6. A chemical vapor deposition apparatus according to claim 1, further comprising a waveguide for connecting the electromagnetic wave generator and the reaction chamber.

7. A chemical vapor deposition apparatus according to claim 6, further comprising an isolator for preventing the counterflow of the electromagnetic waves into the waveguide.

8. A chemical vapor deposition apparatus comprising:
a cavity resonator for placing a substrate therein; and
a substrate heater having an electromagnetic wave generator connecting to the cavity resonator for supplying electromagnetic waves to the cavity resonator.

9. A chemical vapor deposition apparatus according to claim 8, further comprising a holder for holding the substrate in the cavity resonator, the holder being provided with an opening in the region the substrate is placed.

10. A chemical vapor deposition apparatus according to claim 8, wherein the substrate and the holder are arranged so that a structure constituted by the substrate, the holder, and the cavity resonator confines the electromagnetic waves.

11. A chemical vapor deposition apparatus according to claim 8, further comprising a waveguide for connecting the electromagnetic wave generator and the reaction chamber.

12. A chemical vapor deposition apparatus according to claim 8, wherein the cavity resonator is a ring cavity resonator.

13. A chemical vapor deposition apparatus according to claim 12, wherein the ring cavity resonator has a resonant frequency which is different from the frequency of the electromagnetic wave generator.

14. A chemical vapor deposition apparatus according to claim 11, wherein the cavity resonator is a ring cavity resonator, and which has a directional coupler for connecting the ring cavity resonator to the waveguide.

15. A chemical vapor deposition apparatus according to claim 8, wherein the electromagnetic wave generator comprises a plurality of independent electromagnetic wave generating units.

16. A chemical vapor deposition apparatus according to claim 15, wherein the electromagnetic wave generating units are linearly arranged parallel to the plane of the substrate.

17. A chemical vapor deposition apparatus according to claim 11, further comprising an isolator for preventing the counterflow of the electromagnetic waves into the waveguide.

18. A chemical vapor deposition apparatus according to claim 8, wherein the cavity resonator comprises:
a gas supply nozzle for introducing a reaction gas into the cavity resonator; and
a gas exhaust nozzle for discharging the gas from the cavity resonator.

19. A chemical vapor deposition apparatus according to claim 18, wherein the diameter of the gas supply nozzle and the diameter of the gas exhaust nozzle are smaller than the wavelength of the electromagnetic waves.

20. A chemical vapor deposition apparatus according to claim 8, wherein the internal face of the cavity resonator is covered with a coating film which comprises a corrosion-resistant material and reflects radiation from the heated substrate.

21. A chemical vapor deposition apparatus according to claim 8, wherein the cavity resonator has a reaction chamber therein, the substrate being contained in the reaction chamber.
